# EUROPEAN PATENT APPLICATION

(11) **EP 4 617 013 A1**
(43) Date of publication of application: **17.09.2025**
(21) Application number: 23888297.1
(22) Date of filing: 27.07.2023
(51) Int. Cl.: B25J 19/00, B25J 17/00, G06F 30/20, F16H 1/32

(54) **REDUCTION GEAR SELECTION SUPPORT DEVICE**

(30) Priority: 08.11.2022 JP 2022178797
(71) Applicant: Sumitomo Heavy Industries, Ltd., Tokyo 141-6025 (JP)
(72) Inventor: TANAKA, Mitsuharu, Yokosuka-shi, Kanagawa 237-8555 (JP)
(74) Representative: Louis Pöhlau Lohrentz
(86) International application number: PCT/JP2023/027626
(87) International publication number: WO 2024/100942

(57) **Abstract**

A reduction gear selection support device 100 includes a storage unit that stores, in association with information enabling a type of a reduction gear to be specified, characteristic information of the reduction gear, the characteristic information being changed according to a situation change of the reduction gear, a first receiving unit 121 that receives specification information of a robot, a second receiving unit 122 that receives designation of a reduction gear to be incorporated into each joint of the robot, an analysis unit 127 that analyzes a behavior of the robot in which a designated reduction gear is incorporated into each joint, and a result provision unit 129 that provides an analysis result to a user.

## Description

### Technical Field

The present invention relates to a reduction gear selection support device.

### Background Art

A robot is known in which a reduction gear is incorporated into a plurality of joint portions. For example, PTL 1 discloses a robot in which an eccentric oscillating speed reducer is incorporated into a joint portion.

### Citation List

### Patent Literature

[PTL 1] Japanese Unexamined Patent Publication No. 2006-263878

### Summary of Invention

### Technical Problem

A reduction gear to be incorporated into each joint is selected in a case where a robot is designed, but the selection is very laborious.

The present invention has been made in view of such circumstances, and an object of the present invention is to provide a technique of supporting selection of a reduction gear.

### Solution to Problem

In order to solve the above problem, a reduction gear selection support device of an aspect of the present invention includes a storage unit that stores, in association with information enabling a type of a reduction gear to be specified, characteristic information of the reduction gear, the characteristic information being changed according to a situation change of the reduction gear, a first receiving unit that receives specification information of a robot, a second receiving unit that receives designation of a reduction gear to be incorporated into each joint of the robot, an analysis unit that analyzes a behavior of the robot in which a designated reduction gear is incorporated into each joint, and a result provision unit that provides an analysis result to a user.

Another aspect of the present invention is also a reduction gear selection support device. The device includes a storage unit that stores, in association with information enabling a type of a reduction gear to be specified, characteristic information of the reduction gear, the characteristic information being changed according to a situation change of the reduction gear, a first receiving unit that receives specification information of a robot, a fourth receiving unit that receives behavior information of the robot desired to be implemented, a selection unit that selects, from among reduction gears stored in the storage unit, the reduction gear suitable for implementing the behavior received by the fourth receiving unit, and a result provision unit that provides a selection result.

Any combination of the above components and those in which the components and expressions of the present invention are interchanged among methods, devices, systems, and the like are also effective as an aspect of the present invention.

### Advantageous Effects of Invention

According to the present invention, it is possible to provide the technique of supporting the selection of the reduction gear.

### Brief Description of Drawings

Fig. 1 is a schematic diagram showing a configuration of a reduction gear selection support system according to a first embodiment.
Fig. 2 is a block diagram showing a function and a configuration of a reduction gear selection support device of Fig. 1.
Fig. 3 is a diagram showing an example of a selection support screen provided by a screen provision unit in Fig. 2.
Fig. 4 is a graph showing an example of an analysis result provided to a user.
Fig. 5 is a graph showing another example of the analysis result provided to the user.
Fig. 6 is a graph showing still another example of the analysis result provided to the user.
Fig. 7 is a block diagram showing a function and a configuration of the reduction gear selection support device according to a second embodiment.
Fig. 8 is a diagram showing an example of a selection support screen provided by the screen provision unit in Fig. 7.

### Description of Embodiments

Hereinafter, the same reference numeral is assigned to the same or equivalent component, member, and step shown in each drawing, and duplicate description will be omitted as appropriate. Further, a dimension of the member in each drawing is enlarged and reduced as appropriate for easy understanding. Further, a part of the member that is not important for describing the embodiment is omitted and displayed in each drawing.

First, a background of the present invention will be described. A reduction gear to be incorporated into each joint is selected in a case where a robot is designed. In the selection of the reduction gear, for the robot in which a candidate reduction gear is incorporated into the joint, a behavior in a case where the robot is caused to perform a predetermined operation is analyzed by simulation. Characteristic information of the reduction gear required for the analysis is described in a catalog. However, while the characteristic information of the reduction gear is affected by a temperature, a rotational speed, and the like, which are changed by frictional heat of the reduction gear, the characteristic information described in the catalog does not take the influences into account. It is also conceivable that a user oneself specifies the characteristic information taking into account the influences of the temperature, the rotational speed, and the like by using an actual machine of the reduction gear. However, a burden on the user is large, and a man-hour also increases. As described above, the selection of the reduction gear is laborious. The present invention has been made, based on such a finding, to support the selection of the reduction gear.

### (First Embodiment)

An outline will be described before a first embodiment is described in detail. The first embodiment relates to a technique of supporting selection of a reduction gear to be incorporated into a joint of a robot. A reduction gear selection support device of the first embodiment provides a selection support screen on a user terminal. The user terminal receives an input to the selection support screen from the user. The input to the selection support screen includes specification information of the robot being designed, designation of a reduction gear (model number or specification) to be incorporated into the joint of the robot, and an operation of the robot whose behavior is analyzed. The reduction gear selection support device receives the above inputs.

The reduction gear selection support device analyzes the behavior of a robot, specified by a received specification, in which a designated reduction gear is incorporated into the joint, in a case where the robot is caused to execute a received operation, by simulation. Here, the reduction gear selection support device stores the characteristic information for each of a plurality of reduction gears, the characteristic information (friction, angular transmission error, and the like) being changed according to a change in a situation (for example, temperature or the number of rotations). For example, the friction as the characteristic information is stored as a function in which at least the temperature and the number of rotations are variables. Therefore, the reduction gear selection support device can perform highly accurate analysis in consideration of the situation change of the reduction gear. The reduction gear selection support device provides an analysis result analyzed in this manner to the user terminal. The user can use the analysis result as a reference for the selection of the reduction gear.

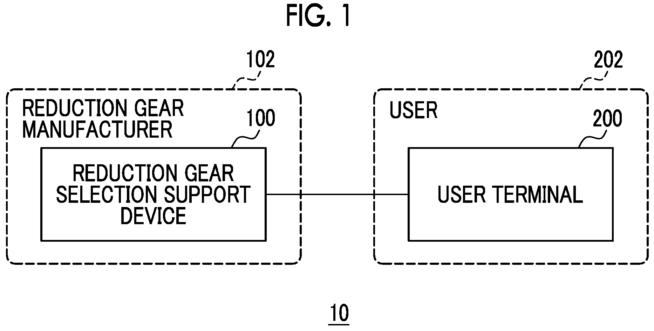

Fig. 1 is a schematic diagram showing a configuration of a reduction gear selection support system 10 of the first embodiment. The reduction gear selection support system 10 includes a reduction gear selection support device 100 and a user terminal 200. The reduction gear selection support device 100 is connected to the user terminal 200 via a network such as the Internet.

The reduction gear selection support device 100 is an information processing device managed by a reduction gear manufacturer 102. The reduction gear manufacturer 102 is a company that manufactures the reduction gear. The reduction gear is a speed reducer or a gear motor (device in which the speed reducer is connected to the motor). The term "managed by reduction gear manufacturer 102" herein includes not only a case where the reduction gear manufacturer 102 directly manages the reduction gear but also a case where a company entrusted by the reduction gear manufacturer 102 manages the reduction gear.

The reduction gear selection support device 100 is configured of a single device (casing) in the present embodiment. However, there is no limitation to the number of physical casings of the reduction gear selection support device 100, and the reduction gear selection support device 100 may be formed by cooperation of a plurality of devices.

The user terminal 200 is an information processing terminal used by a user 202, and is, for example, a general PC, a tablet terminal, or a smartphone. The user 202 is not particularly limited, but is typically a robot manufacturer. That is, the user 202 is a user who selects the reduction gear to be incorporated into the joint of the robot.

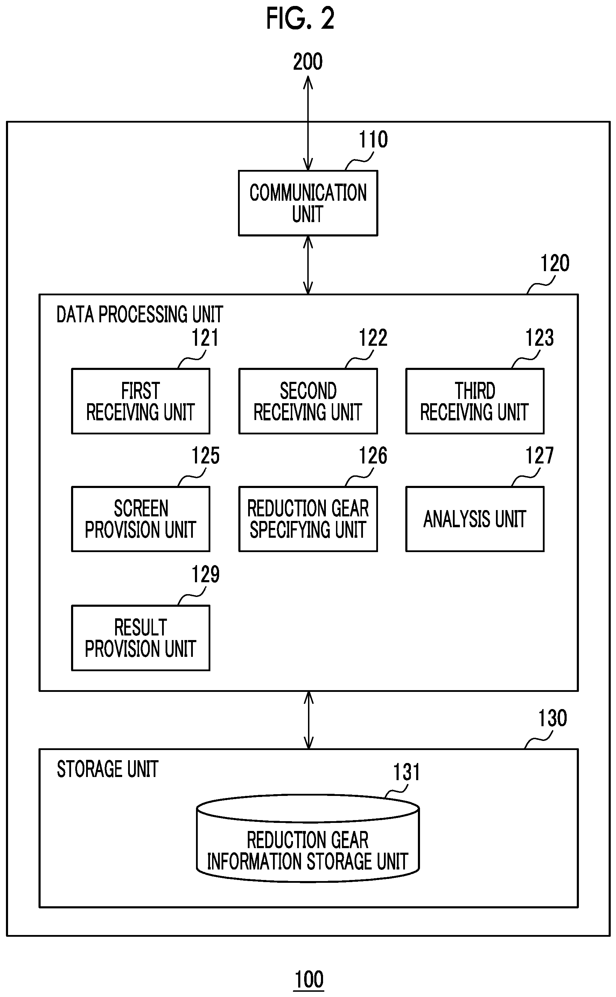

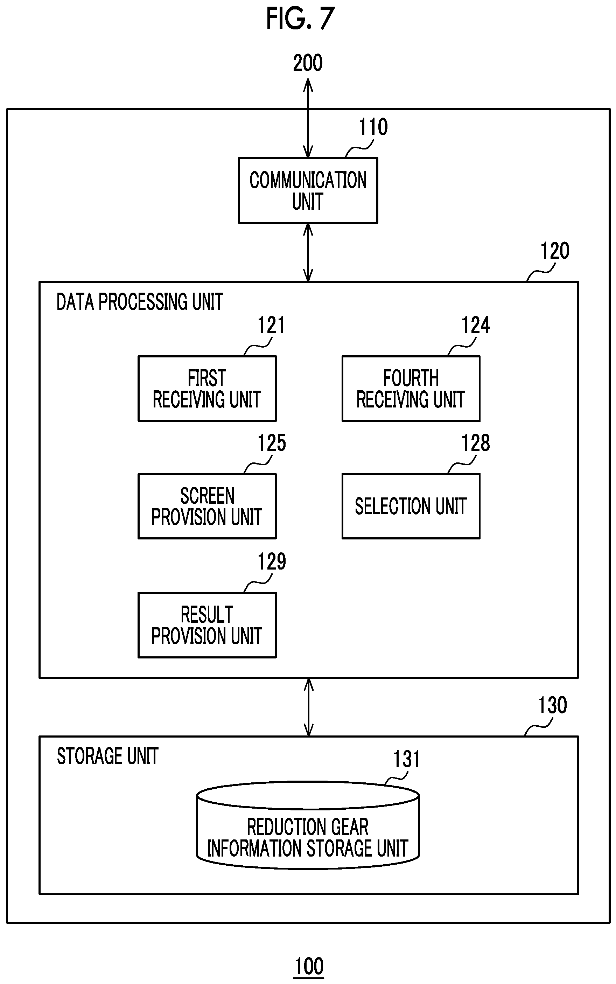

Fig. 2 is a block diagram showing a function and a configuration of the reduction gear selection support device 100. Each block shown here can be formed by an element such as a central processing unit (CPU) of a computer or a machine device in terms of hardware, and can be realized by a computer program in terms of software. However, here, functional blocks realized by cooperation thereof are described. Therefore, it is understood by those skilled in the art that the functional blocks can be realized in various forms by the combination of hardware and software. The same applies to a block diagram of Fig. 7.

The reduction gear selection support device 100 includes a communication unit 110, a data processing unit 120, and a storage unit 130. The communication unit 110 executes communication processing with the user terminal 200 according to various communication protocols. The data processing unit 120 executes various types of data processing based on data acquired by the communication unit 110 or data stored in the storage unit 130. The storage unit 130 stores various types of data prepared in advance and the data received from the communication unit 110 or the data processing unit 120.

The storage unit 130 includes a reduction gear information storage unit 131. The reduction gear information storage unit 131 stores, for each of the plurality of reduction gears, a reduction gear ID for uniquely identifying the reduction gear, information enabling a type of the reduction gear to be specified (hereinafter also referred to as type specification information), and the characteristic information of the reduction gear in association with each other. The type specification information includes a model, frame number, reduction ratio, and the like of the reduction gear.

In a case where the reduction gear is the speed reducer, the characteristic information includes the characteristic information of the speed reducer. In a case where the reduction gear is the gear motor, the characteristic information includes the characteristic information of both the speed reducer and a motor that configure the gear motor. The characteristic information includes the friction, the angular transmission error, and the like. The characteristic information is defined to be changed according to the change in the situation of the reduction gear (for example, temperature or number of rotations). That is, the friction is defined as the function of at least the temperature and the number of rotations as variables. Similarly, the angular transmission error is defined as a function of at least a speed reducer rotation angle as a variable.

The reduction gear information storage unit 131 may store the characteristic information of all the reduction gears manufactured by the reduction gear manufacturer 102. Further, in addition to the characteristic information of the reduction gear being manufactured, the reduction gear information storage unit 131 may store the characteristic information of the reduction gear that has been manufactured in the past (that is, that is no longer manufactured).

The data processing unit 120 includes a first receiving unit 121, a second receiving unit 122, a third receiving unit 123, a screen provision unit 125, a reduction gear specifying unit 126, an analysis unit 127, and a result provision unit 129.

The screen provision unit 125 transmits the selection support screen, which is a screen that supports the selection of the reduction gear, to the user terminal 200 in response to a request to display the selection support screen on a display of the user terminal 200.

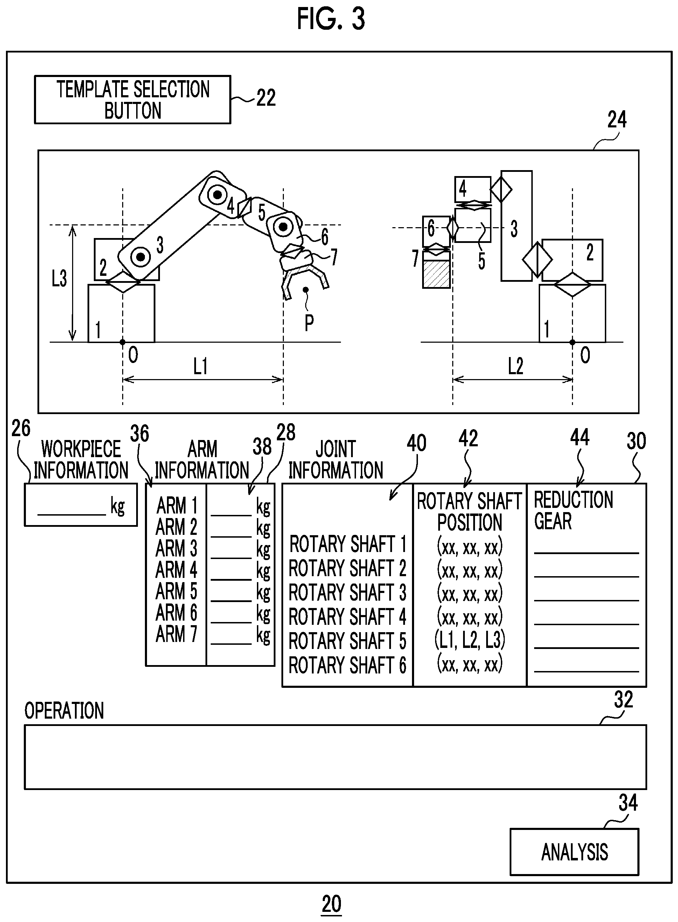

Fig. 3 is a diagram showing an example of a selection support screen 20 provided by the screen provision unit 125 in Fig. 2. The selection support screen 20 includes a template selection button 22, a robot display region 24, a workpiece information field 26, an arm information region 28, a joint information region 30, an operation field 32, and an analysis button 34.

In a case where the template selection button 22 is selected, a list of templates prepared in advance (not shown) is displayed. The user selects a template corresponding to a robot to be configured from the list of the displayed templates. A schematic diagram of the robot of the selected template is displayed in the robot display region 24.

Mass characteristics (weight, centroid position, moment of inertia, or the like) of a workpiece are input to the workpiece information field 26.

The arm information region 28 includes an arm ID field 36 and an arm mass characteristic field 38. An ID for identifying an arm is displayed in the arm ID field 36. The number of arms of the robot is determined by the selection of the template.

The mass characteristics of the arm are input to the arm mass characteristic field 38.

The joint information region 30 includes a rotary shaft (joint) ID field 40, a rotary shaft position field 42, and a reduction gear field 44. An ID for identifying a rotary shaft is displayed in the rotary shaft ID field 40. The number of rotary shafts (joints) of the robot is determined by the selection of the template.

A three-dimensional position of each rotary shaft in a reference posture (for example, initial posture) of the robot, with a predetermined reference point O (refer to the robot display region 24) as an origin, is input to the rotary shaft position field 42. A default value set in the template may be input to the rotary shaft position field 42. In this case, the user may change the rotary shaft position field 42 from the default value as necessary, for example, by a direct input. In the illustration displayed in the robot display region 24, a position of the rotary shaft may be changeable by an operation such as drag and drop, and the input to the rotary shaft position field 42 may be changed accordingly. That is, the rotary shaft position field 42 may be input in a form in which the template is changed.

Information for designating the reduction gear to be incorporated into each rotary shaft, for example, a model, frame number, or specification information of the reduction gear is input to the reduction gear field 44. The specification information of the reduction gear includes, for example, the reduction ratio and a required torque. In a case where the reduction gear is the gear motor, the specification information of the reduction gear includes, for example, the moment of inertia of the motor and a maximum generated torque. In the rotary shaft position field 42, a plurality of pieces of information, for example, a plurality of pieces of specification information may be input for one rotary shaft. For example, in the rotary shaft position field 42, both the reduction ratio and the required torque may be input for one rotary shaft. In a case where the reduction gear does not include the motor, there may be a form in which the moment of inertia of the motor or the maximum generated torque is selected from the template in the same manner as the reduction gear, or there may be a form in which the user can individually designate the moment of inertia of the motor or the maximum generated torque.

The operation of the robot whose behavior is desired to be analyzed is input to the operation field 32. The operation may be, for example, an operation of moving a reference point P of a tool attached to a tip of the arm from a first position to a second position in t seconds. Further, the operation may be, for example, an operation of moving the reference point P of the tool along a three-dimensional target trajectory. The operation may be input in a form set in advance for each type. A control method or a control parameter of the motor in a case where the behavior is analyzed may be in a user adjustable form.

In a case where the analysis button 34 is selected, each information item in Fig. 3 is transmitted to the reduction gear selection support device 100 from the user terminal 200, and the reduction gear selection support device 100 executes analysis described below.

The description returns to Fig. 2. The first receiving unit 121 receives the specification information of the robot whose behavior is analyzed, from the user via the user terminal 200. Specifically, the first receiving unit 121 receives, from the user terminal 200, the information item relating to the specification of the robot, specifically, the mass characteristics of the workpiece, the mass characteristics of the arm, the number of rotary shafts, and the rotary shaft position of each rotary shaft, in the selection support screen 20 in Fig. 3.

The second receiving unit 122 receives the designation of the reduction gear to be incorporated into each joint of the robot, from the user via the user terminal 200. Specifically, the second receiving unit 122 receives, from the user terminal 200, the input to the reduction gear field 44 of the selection support screen 20 in Fig. 3.

The third receiving unit 123 receives the operation of the robot whose behavior is desired to be analyzed, from the user via the user terminal 200. Specifically, the third receiving unit 123 receives, from the user terminal 200, the input to the operation field 32 of the selection support screen 20 in Fig. 3. A configuration is also conceivable in which the data processing unit 120 does not include the third receiving unit 123. In this case, the behavior of the operation set in advance may be analyzed.

The reduction gear specifying unit 126 specifies the reduction gear based on the designation of the reduction gear received by the second receiving unit 122. Specifically, the reduction gear specifying unit 126 specifies, from the reduction gear information storage unit 131, the reduction gear ID of the reduction gear that matches the designation of the reduction gear, which is received by the second receiving unit 122, and specific information of the reduction gear. The plurality of reduction gears may be specified. For example, in a case where information for designating the reduction gear is the specification information of the reduction gear, there may be the plurality of reduction gears that match the specification information, that is, satisfy the specification information. In this case, the reduction gear specifying unit 126 may specify the plurality of reduction gears.

The analysis unit 127 analyzes the behavior in a case where the reduction gear specified by the reduction gear specifying unit 126, based on the designation received by the second receiving unit 122, is incorporated into the joint of the robot having the specification received by the first receiving unit 121 and the robot is caused to execute the operation received by the third receiving unit 123. The analysis unit 127 may perform the analysis by using a known or future available analysis technique. The analysis unit 127 performs the analysis by using, as the characteristic information of the reduction gear incorporated into each joint, the characteristic information stored in the reduction gear information storage unit 131, that is, the characteristic information that changes according to the situation change such as the temperature or the number of rotations.

In a case where the reduction gear specifying unit 126 specifies the plurality of reduction gears for a certain joint, the analysis unit 127 may sequentially incorporate the plurality of reduction gears into the joint and analyze the behaviors in respective cases.

The result provision unit 129 provides the analysis result to the user. For example, the analysis result includes a deviation from a command value at the position of the reference point P of the tool attached to the tip of the arm of the robot, a deviation from a command value at a rotation angle of each rotary shaft, and a comparison between a load applied to the reduction gear and an allowable load included in the characteristic information of the reduction gear. For example, the result provision unit 129 transmits an analysis result screen indicating the analysis result to the user terminal 200 to cause the display of the user terminal 200 to display the analysis result screen.

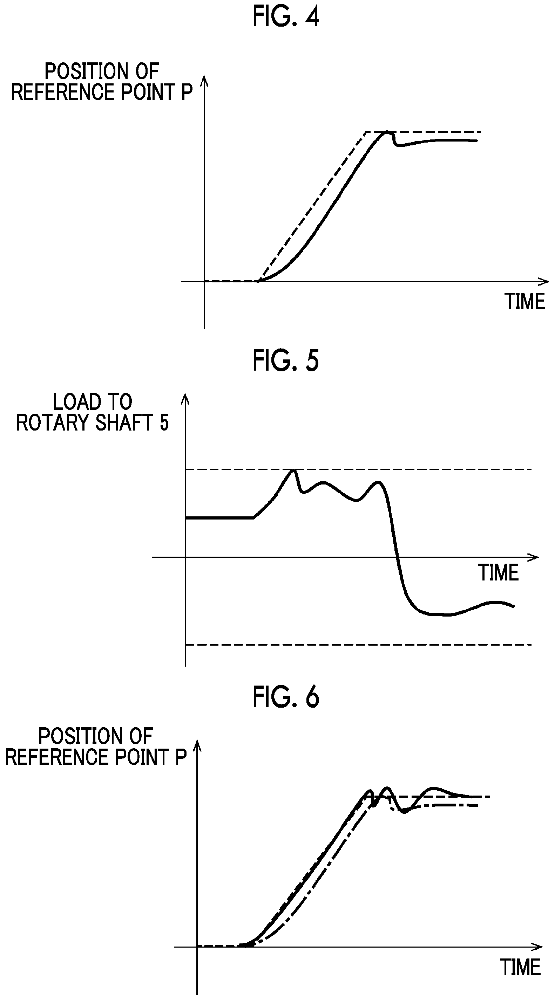

Fig. 4 is a graph showing an example of the analysis result provided to the user. The analysis result of this example is an error between the command value and the position of the reference point P in a case where the reference point P of the tool is moved along the target trajectory. In Fig. 4, the horizontal axis shows time, and the vertical axis shows the position of the reference point P of the tool. The graph of a solid line indicates the analysis result, and the graph of a broken line indicates the command value.

Fig. 5 is a graph showing another example of the analysis result provided to the user. In Fig. 5, the horizontal axis shows time, and the vertical axis shows a load applied to the rotary shaft. The graph of a solid line indicates the analysis result, and the graphs of broken lines indicate the allowable load of the reduction gear.

With checking of the analysis results in Figs. 4 and 5, the user can understand at a glance the behavior of the robot in a case where the designated reduction gear is incorporated.

Fig. 6 is a graph showing still another example of the analysis result provided to the user. The analysis result of this example is an error between the command value and the position of the reference point P in a case where the reference point P of the tool is moved along the target trajectory, as in Fig. 4. This example shows the analysis result in a case where the reduction gear specifying unit 126 specifies a plurality of candidates for the reduction gear for a certain joint and the analysis unit 127 analyzes the behaviors in respective cases. Here, the graphs of a solid line and a one-dot chain line indicate the analysis results, and the graph of a broken line indicates the command value. The analysis result for each of the plurality of candidates is presented, and thus the user can select a more appropriate reduction gear.

The above is the configuration of the reduction gear selection support system 10. Subsequently, an operation thereof will be described. The reduction gear selection support device 100 provides the selection support screen 20 to the user terminal 200 in response to a request. The user inputs, to the selection support screen 20, the specification information of the robot, the designation of the reduction gear to be incorporated into the robot, and the operation of the robot whose behavior is analyzed, via the user terminal 200. In a case where the analysis button 34 of the selection support screen 20 is selected, the user terminal 200 transmits each information item of the selection support screen 20 to the reduction gear selection support device 100. The first receiving unit 121, the second receiving unit 122, and the third receiving unit 123 of the reduction gear selection support device 100 each receive the specification information of the robot, the designation of the reduction gear desired to be incorporated into the robot, and the operation of the robot whose behavior is analyzed. The analysis unit 127 analyzes the behavior in a case where the reduction gear specified based on the designation received by the second receiving unit 122 is incorporated into the joint of the robot having the specification received by the first receiving unit 121 and the robot is caused to execute the operation received by the third receiving unit 123. In this case, the analysis unit 127 performs the analysis by using, as the characteristic information of the reduction gear incorporated into each joint, the characteristic information stored in the reduction gear information storage unit 131, that is, the characteristic information that changes according to the situation change such as the temperature or the number of rotations.

According to the present embodiment, based on the specification information of the robot and the designation of the reduction gear received from the user, the reduction gear selection support device 100 analyzes the behavior of the operation of the robot into which the reduction gear is incorporated and provides the analysis result to the user. Here, the reduction gear selection support device 100 stores, as the characteristic information of the reduction gear, the characteristic information that changes according to the situation change of the reduction gear and executes the analysis in consideration of the situation change of the reduction gear. Therefore, according to the present embodiment, it is possible to execute highly accurate analysis while reducing the burden on the user, and thus appropriately select the reduction gear.

Further, according to the present embodiment, in a case where there are the plurality of reduction gears that match the designation of the reduction gear from the user, the reduction gear selection support device 100 sequentially incorporates the plurality of reduction gears into the joint of the robot, analyzes the behaviors in respective cases, and provides the analysis results to the user. The analysis result in a case where each of the plurality of candidates is incorporated is presented, and thus the user can select a more appropriate reduction gear.

Further, according to the present embodiment, the reduction gear selection support device 100 receives, from the user, the designation of the operation of the robot whose behavior is desired to be analyzed, and analyzes the behavior of the robot in a case where the operation thereof is executed. With the analysis of the behavior in the operation to be actually performed by the robot, it is possible to perform more appropriate selection.

Further, according to the present embodiment, the reduction gear selection support device 100 receives the specification information of the robot, which is input in a form in which the template of the robot prepared in advance is changed. In other words, the user can input the specification information of the robot in the form in which the template of the robot prepared in advance is changed. Accordingly, the burden on the user is reduced.

### (Second Embodiment)

In the first embodiment, the specification of the robot and the designation of the reduction gear desired to be incorporated into the robot are received from the user, and the behavior of the robot in which the reduction gear is incorporated into the joint is analyzed and provided to the user. In a second embodiment, the specification of the robot and a behavior of the robot desired to be realized are received from the user, and a reduction gear suitable for realizing the behavior is selected. Hereinafter, differences from the first embodiment will be mainly described.

Fig. 7 is a block diagram showing a function and a configuration of the reduction gear selection support device 100 of the second embodiment. In the reduction gear selection support device 100 of the second embodiment, the data processing unit 120 includes the first receiving unit 121, a fourth receiving unit 124, the screen provision unit 125, a selection unit 128, and the result provision unit 129.

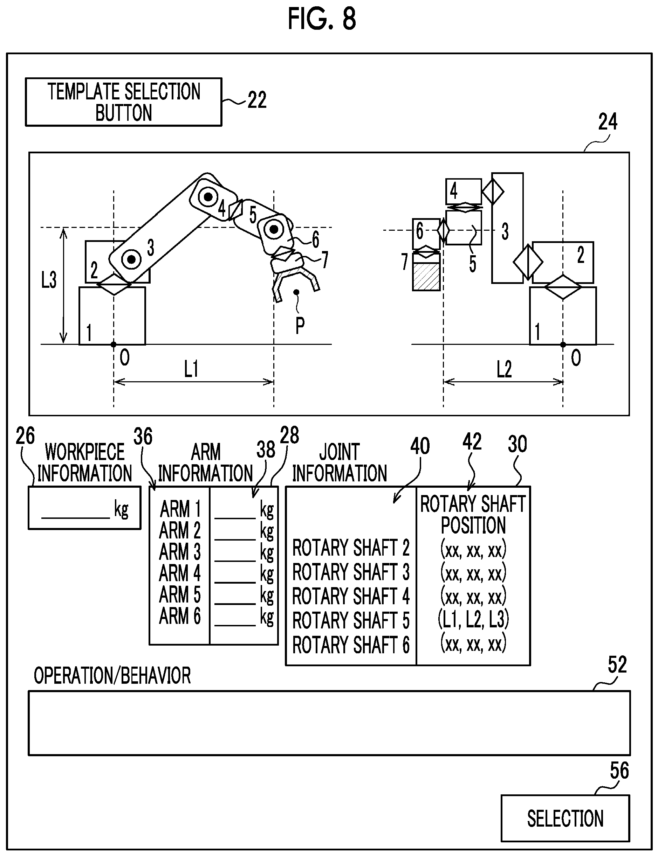

Fig. 8 is a diagram showing an example of a selection support screen 50 provided by the screen provision unit 125 in Fig. 7. The selection support screen 50 includes the template selection button 22, the robot display region 24, the workpiece information field 26, the arm information region 28, the joint information region 30, an operation/behavior field 52, and a selection button 56.

The operation/behavior field 43 designates the operation of the robot whose behavior is desired to be analyzed and the behavior of the robot desired to be realized in a case of the operation. The operation may be, for example, an operation of moving the reference point P of a tool attached to a tip of an arm of the robot from a first position to a second position in t seconds. The behavior desired to be realized in a case of the operation may be that the load applied to the reduction gear is equal to or less than a designated load, or may be that a deviation from a command at a second position, which is an arrival position, is equal to or less than a predetermined value.

Further, the operation may be, for example, an operation of moving the reference point P of the tool along a three-dimensional target trajectory. The behavior desired to be realized in a case of the operation may be that the deviation from the command is equal to or less than the predetermined value.

The description returns to Fig. 2. The fourth receiving unit 124 receives, from the user, the operation of the robot whose behavior is desired to be analyzed and the behavior of the robot desired to be realized in a case of the operation, via the user terminal 200. Specifically, the fourth receiving unit 124 receives, from the user terminal 200, an input to the operation/behavior field 43 of the selection support screen 50 in Fig. 8.

The selection unit 128 selects a reduction gear suitable for realizing the behavior, which is received by the third receiving unit 123, from among the plurality (all) of the reduction gears stored in the reduction gear information storage unit 131. First, the selection unit 128 sequentially incorporates each of the plurality of reduction gears, which are stored in the reduction gear information storage unit 131, into the robot having the specification received by the first receiving unit 121, and analyzes the behavior of the robot for each of the plurality of reduction gears in a case where the robot is caused to execute the operation received by the fourth receiving unit 124. The selection unit 128 selects a combination of the reduction gears that satisfy the behavior desired to be realized, which is received by the fourth receiving unit 124, based on an analysis result.

The result provision unit 129 provides a selection result to the user. The selection result includes information of the selected reduction gear. The selection result may include the result of the analysis executed in a case of the selection, in addition to the information of the selected reduction gear.

Subsequently, an operation of the reduction gear selection support device 100 will be described. The reduction gear selection support device 100 provides the selection support screen 50 to the user terminal 200 in response to a request. The user inputs, to the selection support screen 50, the specification information of the robot, the operation of the robot whose behavior is desired to be analyzed, and the behavior of the robot desired to be realized, via the user terminal 200. In a case where the selection button 56 of the selection support screen 50 is selected, the user terminal 200 transmits each information item of the selection support screen 50 to the reduction gear selection support device 100. The first receiving unit 121 and the fourth receiving unit 124 of the reduction gear selection support device 100 each receive the specification information of the robot, the operation of the robot whose behavior is analyzed, and the behavior of the robot desired to be realized. The selection unit 128 sequentially incorporates each of the plurality of reduction gears, which are stored in the reduction gear information storage unit 131, into the robot having the specification received by the first receiving unit 121, and analyzes the behavior of the robot for each of the plurality of reduction gears in a case where the robot is caused to execute the operation received by the fourth receiving unit 124. In this case, the selection unit 128 performs the analysis by using, as the characteristic information of the reduction gear incorporated into each joint, the characteristic information stored in the reduction gear information storage unit 131, that is, the characteristic information that changes according to the situation change such as the temperature or the number of rotations. The selection unit 128 selects a combination of the reduction gears that satisfy the behavior desired to be realized, based on an analysis result.

According to the present embodiment, the reduction gear selection support device 100 selects the reduction gear suitable for realizing the behavior of the robot, based on the specification information of the robot received from the user, the operation of the robot whose behavior is desired to be analyzed, and the behavior of the robot desired to be realized. Here, the reduction gear selection support device 100 stores, as the characteristic information of the reduction gear, the characteristic information that changes according to the situation change of the reduction gear. Thus, in the analysis of the behavior for the selection, the analysis is executed in consideration of the situation change of the reduction gear. Therefore, according to the present embodiment, it is possible to execute highly accurate analysis while reducing the burden on the user. As a result, it is possible to select a more appropriate reduction gear.

The present invention has been described above based on the embodiments. It should be understood by those skilled in the art that the embodiments are mere examples, various modification examples can be made to the combinations of the respective components and respective processing processes, and such modification examples are also within the scope of the present invention. Further, in the embodiments, the reduction gear selection support device 100 has been mainly described as a device. However, the present invention can also be regarded as a reduction gear selection support method having each step executed by the reduction gear selection support device 100, a program for causing the reduction gear selection support device 100 to execute each step, or a storage medium storing the program.

### Industrial Applicability

The present invention relates to a reduction gear selection support device.

### Reference Signs List

- 10: reduction gear selection support system
- 100: reduction gear selection support device
- 121: first receiving unit
- 122: second receiving unit
- 123: third receiving unit
- 124: fourth receiving unit
- 127: analysis unit
- 129: result provision unit
- 131: reduction gear information storage unit

## Claims

1. A reduction gear selection support device comprising:
a storage unit that stores, in association with information enabling a type of a reduction gear to be specified, characteristic information of the reduction gear, the characteristic information being changed according to a situation change of the reduction gear;
a first receiving unit that receives specification information of a robot;
a second receiving unit that receives designation of a reduction gear to be incorporated into each joint of the robot;
an analysis unit that analyzes a behavior of the robot in which a designated reduction gear is incorporated into each joint; and
a result provision unit that provides an analysis result to a user.

2. The reduction gear selection support device according to claim 1,
wherein, in a case where there are a plurality of reduction gears that match the designation received by the second receiving unit, the analysis unit performs the analysis on the plurality of reduction gears and provides analysis results.

3. The reduction gear selection support device according to claim 1 or 2, further comprising:
a third receiving unit that receives an operation of the robot whose behavior is desired to be analyzed.

4. The reduction gear selection support device according to any one of claims 1 to 3,
wherein the present reduction gear selection support device is configured of a single device.

5. The reduction gear selection support device according to any one of claims 1 to 4,
wherein the reduction gear is a gear motor in which a speed reducer is connected to a motor, and the storage unit stores characteristic information of the speed reducer and the motor.

6. The reduction gear selection support device according to any one of claims 1 to 5,
wherein the first receiving unit receives the specification information of the robot, which is input in a form in which a template of the robot prepared in advance is changed.

7. A reduction gear selection support device comprising:
a storage unit that stores, in association with information enabling a type of a reduction gear to be specified, characteristic information of the reduction gear, the characteristic information being changed according to a situation change of the reduction gear;
a first receiving unit that receives specification information of a robot;
a fourth receiving unit that receives behavior information of the robot desired to be implemented;
a selection unit that selects, from among reduction gears stored in the storage unit, the reduction gear suitable for implementing the behavior received by the fourth receiving unit; and
a result provision unit that provides a selection result.

8. The reduction gear selection support device according to claim 7,
wherein the selection unit analyzes the behavior of the robot in which each of a plurality of reduction gears, which are stored in the storage unit, is incorporated into a joint to select the reduction gear.
